# EUROPEAN PATENT APPLICATION

(11) **EP 4 716 384 A2**
(43) Date of publication of application: **25.03.2026**
(21) Application number: 25203430.1
(22) Date of filing: 19.09.2025
(51) Int. Cl.: H05K 1/11, H05K 1/14, H05K 3/36

(54) **A CONNECTOR-LESS PCB-TO-PCB FITMENT ASSEMBLY FOR COMPACT ELECTRONIC DEVICES**

(30) Priority: 21.09.2024 IN 202421071525
(71) Applicant: Vertiv Corporation, Westerville, OH 43082 (US)
(72) Inventor: Jadhav, Smita Prasad, Westerville, 43082 (US); Ranjane, Ganesh Dilip, Westerville, 43082 (US)
(74) Representative: Cousens, Nico

(57) **Abstract**

An apparatus comprises a sheet metal bracket configured to be mounted near a power source. The sheet metal bracket includes a plurality of notched sections along an edge, each notched section defining a mounting feature with one or more apertures configured to receive and retain one or more electrical equipment devices in a fixed position relative to the power source using a fastening element. The apparatus further includes a wire trough integrated with the sheet metal bracket and configured to contain and route wiring from the electrical equipment devices in an organized manner.

## Description

The present disclosure relates to the field of electronic circuit design, particularly to a connector-less PCB-to-PCB (PCB: printed circuit board) fitment assembly for compact electronic devices.

### BACKGROUND

The subject matter discussed in the background section should not be assumed to be prior art merely as a result of its mention in the background section. Similarly, a problem mentioned in the background section or associated with the subject matter of the background section should not be assumed to have been previously recognized in the prior art. The subject matter in the background section merely represents different approaches, which in and of themselves may also correspond to implementations of the claimed technology.

Conventionally, traditional mechanisms for connecting printed circuit boards (PCBs) often rely on various types of electrical connectors, such as pin headers, sockets, or plug-in modules. While these connectors serve their purpose of ensuring secure electrical communication between different PCBs, they inadvertently add complexity to the overall circuit design. This added complexity is not only reflected in the increased number of parts that need to be sourced, assembled, and tested, but also in the additional steps required during manufacturing and quality control. Moreover, connectors contribute to higher production costs and may present potential points of failure due to wear and tear, poor contact over time, or issues arising during repeated assembly and disassembly.

Drawbacks associated with connectors become more pronounced in compact electronic devices where spatial constraints are stringent. For instance, in energy meters, smart meters, handheld instruments, or similar compact devices, available internal space is strictly limited by the fixed dimensions of the device casing. Integrating bulky connectors between a multilayer PCB and a single-layer PCB demands extra room, which often results in the need to increase the size of the main PCB to accommodate both the connector and the surrounding components. This can lead to underutilized space on the PCB, inefficient layout, or in some cases, a complete redesign of the casing to house the larger board, which may not be commercially viable.

Furthermore, reliance on connectors can negatively impact the mechanical stability of the assembly. In devices that may be subjected to vibration, shocks, or thermal cycling, connectors can loosen over time, compromising the electrical connection and leading to intermittent faults that are difficult to diagnose. Additionally, the process of manually plugging or soldering connectors introduces variability and can complicate automated assembly lines, which increasingly rely on surface-mount technologies and compact modular designs to meet the demands for miniaturized electronics.

In light of these limitations, the conventional approach using connectors often fails to satisfy the fitment, durability, and cost-effectiveness requirements of modern compact electronic devices. There is, therefore, a felt need in the industry for an improved solution that eliminates the dependence on connectors altogether.

### SUMMARY

This summary is provided to introduce aspects related to a connector-less PCB-to-PCB fitment assembly for compact electronic devices, and the aspects are further described below in the detailed description. This summary is not intended to identify essential features of the claimed subject matter, nor is it intended for use in determining or limiting the scope of the claimed subject matter.

A connector-less PCB-to-PCB fitment assembly for compact electronic devices is disclosed. The assembly comprises a first printed circuit board (PCB) having a plurality of flanges along a longitudinal edge, and a second PCB having a plurality of slots formed near a longitudinal edge. The plurality of flanges of the first PCB is configured to interlock with the plurality of slots of the second PCB, forming a direct edge-to-edge connection, enabling mechanical and or electrical coupling without the use of connectors, resulting in compact configuration and enhanced component placement.

In an aspect of the present disclosure, at least one of the first PCB or second PCB is a multilayer PCB.

In an aspect of the present disclosure, the first and second PCBs are multilayer PCBs.

In an aspect of the present disclosure, the first PCB and the second PCB are a four-layer PCB.

In an aspect of the present disclosure, the first layer of the first PCB includes at least one flange of the plurality of flanges, and a layer of the second PCB includes the plurality of slots.

In an aspect of the present disclosure, the plurality slots are configured in the third layer and the four-layer the first PCB, and the plurality of flanges in the first layer of the first PCB engage with the plurality of slots of the second PCB to enable physical and electrical connection.

In an aspect of the present disclosure, the edge-to-edge connection between the first PCB and the second PCB includes alignment features, comprising one or more depressions or protrusions in the plurality of flanges and the plurality of slots, ensuring precise alignment and preventing misalignment during assembly.

In an aspect of the present disclosure, the plurality of flanges and the plurality of slots are configured to engage through mechanical interlocking, thereby enhancing the robustness of the mechanical connection, and enhancing durability under mechanical stress or vibration.

In an aspect of the present disclosure, the first PCB comprises a heat-dissipating layer configured to maintain the thermal stability of the assembly, and the second PCB is optimized for reduced power consumption, ensuring overall system efficiency.

In an aspect of the present disclosure, plurality of flanges are configured to distribute stress evenly across the connection during soldering and operation, thereby improving the structural integrity of the connection over time, reducing the likelihood of mechanical failure.

In an aspect of the present disclosure, the connector-less configuration eliminates the need for additional connector components, reducing the overall weight and cost of the assembly, and allowing for more compact configurations suitable for space-constrained applications such as energy meters, mobile devices, and other compact electronic systems.

In an aspect of the present disclosure, the assembly further comprises an additional layer of conductive material applied to the plurality of flanges of the first PCB and the plurality of slots of the second PCB to enhance electrical conductivity and signal transmission, optimizing the assembly for high-frequency or RF applications.

In an aspect of the present disclosure, the connector-less PCB-to-PCB fitment enables enhanced scalability by simplifying the production process, allowing for high-volume production with reduced assembly complexity and increased throughput.

In an aspect of the present disclosure, the plurality of flanges and the plurality of slots are configured to provide minimal impedance discontinuity, thereby improving signal integrity and reducing interference in high-speed data transmission applications.

In an aspect of the present disclosure, the edge-to-edge connection allows for further miniaturization of the device, by enabling optimal component placement and eliminating the need to increase the size of the PCB to accommodate connectors, thus allowing the entire assembly to fit within fixed casing dimensions.

In an aspect of the present disclosure, the first PCB and said second PCB are configured to be manufactured using automated processes such as pick-and-place technology and wave soldering, further reducing assembly time and cost, making the assembly more suitable for high volume production.

In an aspect of the present disclosure, the direct edge-to-edge connection between the first PCB and the second PCB eliminates parasitic inductance and capacitance that would otherwise be introduced by connectors, thereby improving electrical performance in sensitive electronic applications.

In an aspect of the present disclosure, the plurality of flanges of the first PCB and the plurality of slots of the second are fabricated using precision etching or milling techniques to ensure dimensional accuracy and repeatability in mass production.

In an aspect of the present disclosure, the first PCB and said second PCB are configured with surface finish treatments, such as immersion gold or immersion silver, to enhance solderability and long-term reliability of the assembly.

In an aspect of the present disclosure, the plurality of flanges and the plurality of slots are configured to allow for disassembly and rework of the assembly without damaging the PCBs, allowing for easier repair and maintenance.

In an aspect of the present disclosure, the edge-to-edge connection between the first PCB and the second PCB provides increased configuration flexibility for engineers to optimize PCB layout and electrical performance, free from the constraints imposed by traditional connectors.

In an aspect of the present disclosure, the assembly is optimized for environmental sustainability by reducing the number of components, minimizing material waste, and simplifying the recycling process by eliminating the need for connectors.

In an aspect of the present disclosure, the first PCB and the second PCB are interchangeable.

Other aspects and advantages of the claimed invention will become apparent from the following description, taken in conjunction with the accompanying drawings, illustrating by way of example the principles of the claimed invention.

### BRIEF DESCRIPTION OF THE DRAWINGS

The accompanying drawings constitute a part of the description and are used to provide a further understanding of the present disclosure. In the drawings:
Fig. 1 illustrates a multi-layer PCB (printed circuit board) with flanges, in accordance with the present disclosure;
**Fig.** 2 illustrates a single-layer PCB (printed circuit board) with slots, in accordance with the present disclosure;
**Fig.** 3 illustrates an edge-to-edge connection between the multi-layer PCB and the single-layer PCB using the flanges and slots provided therein, in accordance with the present disclosure; and
**Fig.** 4 illustrates a side view of an edge-to-edge connection between the multi-layer PCB and the single-layer PCB using the flanges and slots, in accordance with the present disclosure.

A more complete understanding of the presently claimed invention and its embodiments thereof may be acquired by referring to the following description and the accompanying drawings.

### DETAILED DESCRIPTION

Exemplary embodiments will now be described with reference to the accompanying drawings. The disclosure may, however, be embodied in many different forms and should not be construed as limited to the embodiments set forth herein; rather, these embodiments are provided so that this disclosure will be thorough and complete, and will fully convey its scope to those skilled in the art. The terminology used in the detailed description of the particular exemplary embodiments illustrated in the accompanying drawings is not intended to be limiting. In the drawings, like numbers refer to like elements.

It is to be noted, however, that the reference numerals used herein illustrate only typical embodiments of the present subject matter, and are therefore not to be considered for limiting its scope, for the subject matter may admit to other equally effective embodiments.

The detailed description includes specific details for the purpose of providing a thorough understanding of the presently claimed invention. However, it will be apparent to those skilled in the art that the presently claimed invention may be practiced without these specific details.

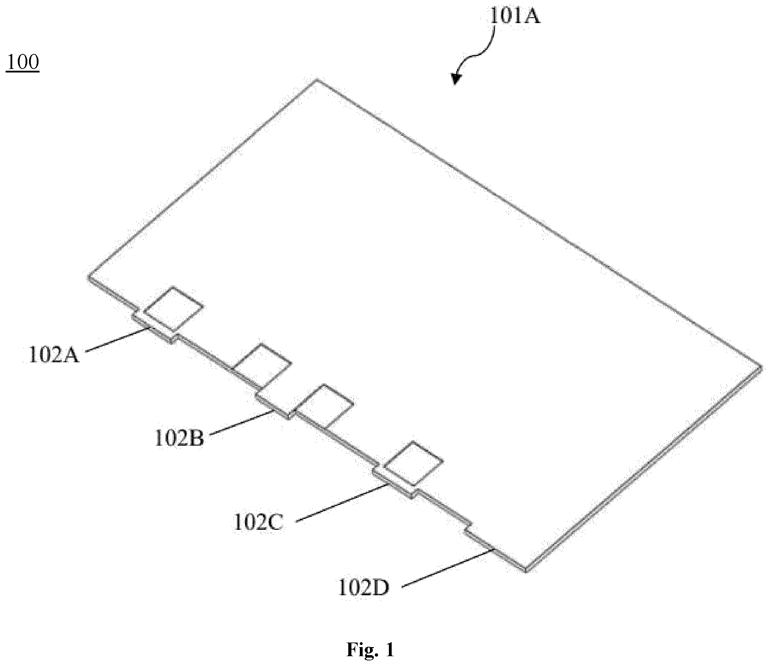

A connector-less PCB-to-PCB (printed circuit board-to-printed circuit board) fitment assembly for compact electronic devices of the present disclosure will now be described in detail with reference to **Fig. 1** through **Fig. 4****.** The preferred embodiment does not limit the scope and ambit of the present disclosure.

The present disclosure proposes a connector-less PCB-to-PCB fitment assembly **100** where two PCBs (printed circuit boards) are directly connected along their edges.

In accordance with one aspect, this disclosure provides a connector-less PCB-to-PCB fitment assembly **100** for compact electronic devices, comprising a first printed circuit board PCB **101A** having a plurality of flanges **102A, 102B, 102C, 102D** along a longitudinal edge, a second printed circuit board PCB **101B** having a plurality of slots **103A, 103B, 103C, 103D** formed near a longitudinal edge, and wherein the plurality of flanges **102A, 102B, 102C, 102D** of the first PCB **101A** is configured to interlock with the plurality of slots **103A, 103B, 103C, 103D** of the second PCB **101B,** thereby forming a direct edge-to-edge connection, enabling mechanical and or electrical coupling without the use of connectors, resulting in compact configuration and enhanced component placement.

Either one of the first PCB or second PCB is a multilayer PCB. The first and second PCBs are multilayer PCBs.

In an implementation, the first PCB **101A** and the second PCB **101B** is a four-layer PCB.

The first layer of the first PCB includes flanges **102A, 102B, 102C, 102D** and another layer of the second PCB includes slots **103A, 103B, 103C, 103D.** The slots **103A, 103B, 103C, 103D** may be configured in the third layer of the four-layer PCB, and the flanges **102A, 102B, 102C, 102D** in the first layer of the first PCB **101A** engage with the slot **103A, 103B, 103C, 103D of** the second PCB **101B** to enable physical and electrical connection.

The edge-to-edge connection between the first PCB **101A** and the second PCB **101B** includes alignment features, comprising one or more depressions or protrusions in the flanges **102A, 102B, 102C, 102D** and the slots **103A, 103B, 103C, 103D,** ensuring precise alignment and preventing misalignment during assembly.

The plurality of flanges **102A, 102B, 102C, 102D** and the plurality of slots **103A, 103B, 103C, 103D** are configured to engage through mechanical interlocking, thereby enhancing the robustness of the mechanical connection, and further enhancing durability under mechanical stress or vibration.

The first PCB **101A** comprises a heat-dissipating layer configured to maintain the thermal stability of the assembly and the second PCB **101B** is optimized for reduced power consumption, ensuring overall system efficiency.

The flanges **102A, 102B, 102C, 102D** may be configured to distribute stress evenly across the connection during soldering and operation, thereby improving the structural integrity of the connection over time, reducing the likelihood of mechanical failure.

The connector-less configuration eliminates the need for additional connector components, reducing the overall weight and cost of the assembly, and allowing for more compact configurations suitable for space-constrained applications such as energy meters, mobile devices, and other compact electronic systems. Further, the connector-less PCB-to-PCB fitment assembly **100** comprises an additional layer of conductive material applied to the flanges **102A, 102B, 102C, 102D** of the first PCB **101A** and the slots **103A, 103B, 103C, 103D** of the second PCB **101B** to enhance electrical conductivity and signal transmission, optimizing the assembly for high-frequency or RF applications. The connector-less PCB-to-PCB fitment enables enhanced scalability by simplifying the production process, allowing for high-volume production with reduced assembly complexity and increased throughput.

The flanges **102A, 102B, 102C, 102D** and the slots **103A, 103B, 103C, 103D** may be configured to provide minimal impedance discontinuity, thereby improving signal integrity and reducing interference in high-speed data transmission applications. The edge-to-edge connection allows for further miniaturization of the device, by enabling optimal component placement and eliminating the need to increase the size of the PCB to accommodate connectors, thus allowing the entire assembly to fit within fixed casing dimensions.

The first PCB **101A** and the second PCB **101B** are configured to be manufactured using automated processes such as pick-and-place technology and wave soldering, further reducing assembly time and cost, making the assembly more suitable for high-volume production. The direct edge-to-edge connection between the first PCB **101A** and the second PCB **101B** eliminates parasitic inductance and capacitance that would otherwise be introduced by connectors, thereby improving electrical performance in sensitive electronic applications.

The flanges **102A, 102B, 102C, 102D** of the first PCB **101A** and the slots **103A, 103B, 103C, 103D** of the second PCB **101B** are fabricated using precision etching or milling techniques to ensure dimensional accuracy and repeatability in mass production.

The first PCB **101A** and the second PCB **101B** may be configured with surface finish treatments, such as immersion gold or immersion silver, to enhance solderability and long-term reliability of the assembly.

The flanges **102A, 102B, 102C, 102D** and the slots **103A, 103B, 103C, 103D** can be configured to allow for disassembly and rework of the assembly without damaging the PCBs, allowing for easier repair and maintenance.

The edge-to-edge connection between the first PCB **101A** and the second PCB **101B** provides increased configuration flexibility for engineers to optimize PCB layout and electrical performance, free from the constraints imposed by traditional connectors.

The assembly is optimized for environmental sustainability by reducing the number of components, minimizing material waste, and simplifying the recycling process by eliminating the need for connectors.

It may be understood that the first PCB and the second PCB can be interchangeable.

**Fig. 1** illustrates a multi-layer PCB **101A** with a plurality of outlined flanges **102** on one longitudinal edge. In an embodiment, the multi-layer PCB **101A** can be a four-layer PCB.

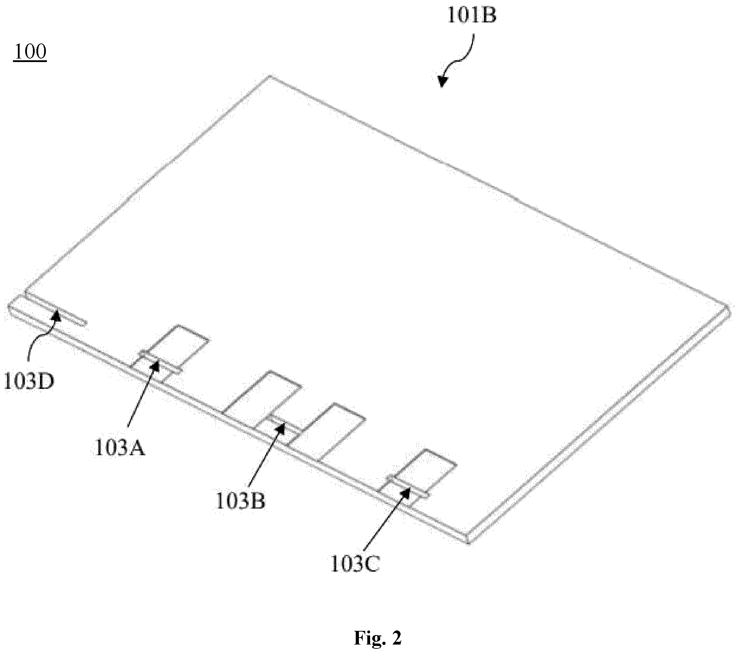

**Fig. 2** illustrates a single-layer PCB **101B** with a simplified circuit layout and a plurality of slots **103** formed near one longitudinal edge. The plurality of slots **103** of the single-layer PCD **101B** are configured to receive and interlock the corresponding flanges **102** of the multi-layer PCB **101A.** For example, the flange **102A** of the multilayer PCB **101A** is interlocked with the slot **103A** of the single-layer PCD **101B,** the flange **102B** of the multi-layer PCB **101A** is interlocked with the slot **103B** of the single-layer PCD **101B,** the flange **102C** of the multi-layer PCB **101A** is interlocked with the slot **103C** of the single-layer PCD **101B,** and the flange **102D** of the multi-layer PCB **101A** is interlocked with the slot **103D** of the single-layer PCD **101B.**

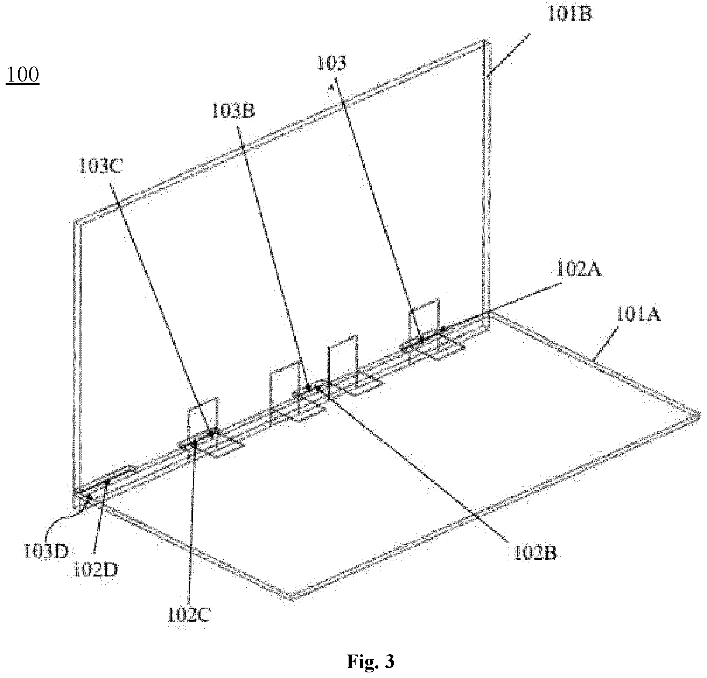

**Fig. 3** illustrates an edge-to-edge connection between the multi-layer PCB (printed circuit board) **101A** and the single-layer PCB (printed circuit board) **101B** using the flanges **102** and the slots **103.** The flanges **102** are strategically outlined along the one longitudinal edge of the multi-layer PCB **101A** to facilitate the direct soldering in the slots **103** formed in the single-layer PCB **101B,** ensuring robust electrical and mechanical connections. The interlocking design prevents misalignment during soldering and enhances the mechanical integrity of the connector-less PCB-to-PCB fitment assembly **100.** This assembly **100** ensures electrical connectivity without the need for additional connectors, providing a more compact and cost-effective solution.

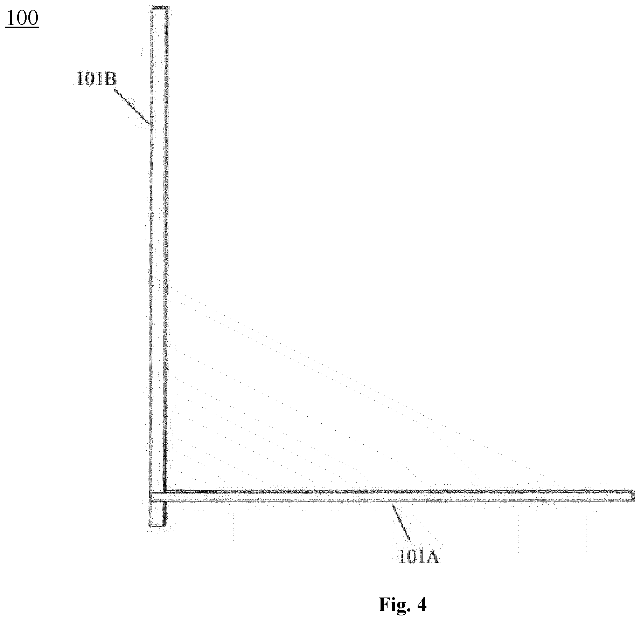

**Fig. 4** illustrates a side view of an edge-to-edge connection between the multi-layer PCB and the single-layer PCB using the flanges and slots. **Fig. 4** shows assembly consists of a PCB **(101A)** positioned horizontally and a PCB (101B) positioned vertically. The two PCBs are interconnected in a perpendicular orientation, demonstrating a direct edge-to-edge connection without the use of connectors. This configuration allows for compact and efficient placement of components, ensuring robust mechanical and electrical connections between the two PCBs while optimizing space within the device.

The flanges **102** may include depressions (not shown) that ensure a solid connection with corresponding protrusions (not shown) formed on the slots **103** when the soldering arrangement is properly assembled.

The single-layer configuration of the PCB **101B** reduces material costs and simplifies manufacturing while maintaining the required electrical connectivity.

In an implementation, the two PCBs **101A, 101B** are aligned edge-to-edge, with the multilayer PCB's **101A** edge slightly overlapping the single-layer PCB's **101B** edge. This overlap allows for precise positioning during soldering, ensuring a secure connection. The interlocking notches or grooves may be included in the PCB design to facilitate mechanical alignment and prevent misalignment during the formation of the assembly 100. The direct PCB-to-PCB connection in the assembly 100 provides improved signal integrity by minimizing impedance discontinuities and signal degradation. Also, the elimination of connectors reduces the overall size, cost, and complexity of the PCB assembly 100.

In one implementation, both PCB boards **101A, 101B** are multilayered boards. In accordance with variation of this implementation, first layer of one multilayer board **101B** includes a flange **102A, 102B, 102C, 102D** and another layer of the second multilayer board **101A** includes slots **103A, 103B, 103C, 103D.**

Typically, and by the way of example, in second multilayer board **101A** the slots **103A, 103B, 103C, 103D** are provided in third multilayer and in such an embodiment, the flanges **102A, 102B, 102C, 102D** of first PCB **101B** engages with the slots **103A, 103B, 103C, 103D** of second PCB **101A** to enable physical and electrical connection.

In one implementation, the first PCB and the second PCB can be interchangeable such that either the first PCB can consist of flanges **102A, 102B, 102C, 102D,** and the second PCB consists of slots **103A, 103B, 103C, 103D** or first PCB can consist of slots **103A, 103B, 103C, 103D** and second PCB consist of flanges **102A, 102B, 102C, 102D.**

The foregoing description of the embodiments has been provided for purposes of illustration and is not intended to limit the scope of the present disclosure. Individual components of a particular embodiment are generally not limited to that particular embodiment, but, are interchangeable. Such variations are not to be regarded as a departure from the present disclosure, and all such modifications are considered to be within the scope of the present disclosure.

### Technical Advancement and Economic Significance

The connector-less PCB-to-PCB fitment assembly for compact electronic devices disclosed in the presently claimed invention may have the following advantages over prior art:
- Eliminates connectors to reduce the physical footprint of the assembly, allowing for more compact designs and efficient use of space;
- Reduces BOM (bill of materials) costs by eliminating connectors and simplifying the assembly process, leading to lower production costs;
- Minimize impedance discontinuities and signal degradation, enhance electrical performance in high-frequency applications; and
- Simplifies the manufacturing process, making it more suitable for high-volume production and scalable to different product designs.

### LIST OF REFERENCE NUMERALS

**100-** Connector-Less PCB-to-PCB Fitment Assembly
**101A-** Multi-Layer PCB/first PCB
**101B-** Single-Layer PCB/second PCB
**(102A, 102B, 102C, 102D)-** Flange
**(103A, 103B, 103C, 103D)-** Slot

The specification may refer to "an", "another", "one", or "some" embodiment(s) in several locations.

This does not necessarily imply that each such reference is to the same embodiment(s), or that the feature only applies to a single embodiment. Single features of different embodiments may also be combined to provide other embodiments.

The terms "or" and "and/or" as used herein are to be interpreted as inclusive or meaning any one or any combination. Therefore, "A, B or C" or "A, B and/or C" means "any of the following: A; B; C; A and B; A and C; B and C; A, B and C." An exception to this definition will occur only when a combination of elements, functions, steps, or acts is in some way inherently mutually exclusive.

As used herein, the singular forms "a", "an", and "the" are intended to include the plural forms as well, unless expressly stated otherwise. It will be further understood that the terms "includes", "comprises", "including" and/or "comprising" when used in this specification, specify the presence of stated features, integers, steps, operations, elements, and/or components, but do not preclude the presence or addition of one or more other features, integers, steps, operations, elements, components, and/or groups thereof. It will be understood that when an element is referred to as being "connected" or "coupled" to another element, it can be directly connected or coupled to the other element or intervening elements may be present. Furthermore, "connected" or "coupled" as used herein may include operatively connected or coupled. As used herein, the term "and/or" includes any and all combinations and arrangements of one or more of the associated listed items.

Unless otherwise defined, all terms (including technical and scientific terms) used herein have the same meaning as commonly understood by one of ordinary skill in the art to which this disclosure pertains. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Although implementations of a connector-less PCB-to-PCB fitment assembly for compact electronic devices have been described in language specific to structural features and/or methods, it is to be understood that the appended claims are not necessarily limited to the specific features or methods described. Rather, the specific features and methods are disclosed as examples of implementations of a connector-less PCB-to-PCB fitment assembly for compact electronic devices.

The presently claimed invention has been described above with reference to numerous embodiments and specific examples. Many variations will suggest themselves to those skilled in this art in light of the above-detailed description. All such obvious variations are within the full intended scope of the appended claims.

## Claims

1. A connector-less PCB-to-PCB fitment assembly **(100)** for compact electronic devices, comprising:
a first printed circuit board "PCB" **(101A)** having a plurality of flanges **(102A, 102B, 102C, 102D)** along a longitudinal edge;
a second PCB (101B) having a plurality of slots **(103A, 103B, 103C, 103D)** formed near a longitudinal edge; and
wherein the plurality of flanges of the first PCB is configured to interlock with the plurality of slots of the second PCB, forming a direct edge-to-edge connection, enabling mechanical and or electrical coupling without the use of connectors, resulting in compact configuration and enhanced component placement.

2. The assembly as claimed in claim 1, wherein at least one of the first PCB or second PCB is a multilayer PCB.

3. The assembly as claimed in claim 1 or 2, wherein the first and second PCBs are multilayer PCBs.

4. The assembly as claimed in claim 3, wherein the first PCB and the second PCB are a four-layer PCB.

5. The assembly as claimed in claim 4, wherein the first layer of the first PCB includes at least one flange of the plurality of flanges and a layer of the second PCB includes the plurality of slots and/or
wherein the plurality slots are configured in the third layer and the four-layer the first PCB, and the plurality of flanges in the first layer of the first PCB engage with the plurality of slot of the second PCB to enable physical and electrical connection.

6. The assembly as claimed in any of claims 2 to 5, wherein the edge-to-edge connection between the first PCB and the second PCB includes alignment features, comprising one or more depressions or protrusions in the plurality of flanges and the plurality of slots , ensuring precise alignment and preventing misalignment during assembly.

7. The assembly as claimed in any preceding claim, wherein the plurality of flanges and the plurality of slots are configured to engage through mechanical interlocking, thereby enhancing the robustness of the mechanical connection, and enhancing durability under mechanical stress or vibration, and/or
wherein the plurality of flanges are configured to distribute stress evenly across the connection during soldering and operation, thereby improving the structural integrity of the connection over time, reducing the likelihood of mechanical failure.

8. The assembly as claimed in any preceding claim, wherein the first PCB comprises a heat-dissipating layer configured to maintain the thermal stability of the assembly, and the second PCB is optimized for reduced power consumption, ensuring overall system efficiency.

9. The assembly as claimed in any preceding claim, wherein the connector-less configuration eliminates the need for additional connector components, reducing the overall weight and cost of the assembly, and allowing for more compact configurations suitable for space-constrained applications such as energy meters, mobile devices, and other compact electronic systems, and/or
wherein the connector-less PCB-to-PCB fitment enables enhanced scalability by simplifying the production process, allowing for high-volume production with reduced assembly complexity and increased throughput.

10. The assembly as claimed in any preceding claim, further comprises an additional layer of conductive material applied to the plurality of flanges of the first PCB and the plurality of slots of the second PCB to enhance electrical conductivity and signal transmission, optimizing the assembly for high-frequency or RF applications.

11. The assembly as claimed in any preceding claim, wherein the edge-to-edge connection allows for further miniaturization of the device, by enabling optimal component placement and eliminating the need to increase the size of the PCB to accommodate connectors, thus allowing the entire assembly to fit within fixed casing dimensions, and/or
wherein the edge-to-edge connection between the first PCB and the second PCB provides increased configuration flexibility for engineers to optimize PCB layout and electrical performance, free from the constraints imposed by traditional connectors.

12. The assembly as claimed in any preceding claim, wherein the first PCB and said second PCB are configured to be manufactured using automated processes such as pick-and-place technology and wave soldering, further reducing assembly time and cost, making the assembly more suitable for high volume production, and/or
wherein the direct edge-to-edge connection between the first PCB and the second PCB eliminates parasitic inductance and capacitance that would otherwise be introduced by connectors, thereby improving electrical performance in sensitive electronic applications.

13. The assembly as claimed in any preceding claim, wherein the plurality of flanges and the plurality of slots are configured to provide minimal impedance discontinuity, thereby improving signal integrity and reducing interference in high-speed data transmission applications, and/or
wherein the plurality of flanges of the first PCB and the plurality of slots of the second PCB are fabricated using precision etching or milling techniques to ensure dimensional accuracy and repeatability in mass production, and/or
wherein the plurality of flanges and the plurality of slots are configured to allow for disassembly and rework of the assembly without damaging the PCBs, allowing for easier repair and maintenance.

14. The assembly as claimed in any preceding claim, wherein the first PCB and said second PCB are configured with surface finish treatments, such as immersion gold or immersion silver, to enhance solderability and long-term reliability of the assembly.

15. The assembly as claimed in any preceding claim, wherein the assembly is optimized for environmental sustainability by reducing the number of components, minimizing material waste, and simplifying the recycling process by eliminating the need for connectors, and/or
wherein the first PCB and the second PCB are interchangeable.
